# EUROPEAN PATENT SPECIFICATION

(11) **EP 2 821 642 B1**
(45) Date of publication and mention of the grant of the patent: **15.11.2017**
(21) Application number: 14164339.5
(22) Date of filing: 11.04.2014
(51) Int. Cl.: F03D 80/60

(54) **Wind turbine generator system**
Windturbinengeneratorsystem
Système de génération d'énergie éolienne

(30) Priority: 01.07.2013 JP 2013138103
(43) Date of publication of application: 07.01.2015
(73) Proprietor: Kabushiki Kaisha Yaskawa Denki, Kitakyushu-shi, Fukuoka 806-0004 (JP)
(72) Inventor: Oba, Koichi, Kitakyushu-shi, Fukuoka 806-0004 (JP); Fujii, Junji, Kitakyushu-shi, Fukuoka 806-0004 (JP); Watanabe, Eiji, Kitakyushu-shi, Fukuoka 806-0004 (JP); Miyamoto, Yasuhiro, Kitakyushu-shi, Fukuoka 806-0004 (JP)
(74) Representative: Viering, Jentschura & Partner mbB Patent- und Rechtsanwälte

(56) References cited:
- US-A1- 2011 211 958

## Description

### BACKGROUND

### 1. Field

The present disclosure relates to a wind turbine generator system.

### 2. Description of the Related Art

Wind turbine generator systems that include an auxiliary to perform tasks such as cooling of a power generator have been made available in response to increasing size and output power of power generation systems. Such a wind turbine generator system including an auxiliary to perform tasks such as the cooling of a power generator is described in, for example, WO/2012/120595.

Another prior art example, which is considered to be the closest prior art and is the basis for the preamble of claim 1 can be seen in document US2011211958.

### SUMMARY

This type of wind turbine generator system including an auxiliary requires electric power to operate the auxiliary. Hence, the amount of output power of such a wind turbine generator system is obtained by subtracting the amount of electric power consumed by the auxiliary from the amount of electric power generated. To improve the efficiency of power generation, there is a demand for restriction of electric power consumption by an auxiliary in this type of wind turbine generator system

It is therefore an object of this disclosure to provide a wind turbine generator system capable of efficient power generation.

A wind turbine generator system for generating electric power from wind power according to the present disclosure includes a conversion unit configured to convert the electric power generated; a first cooling unit configured to cool the conversion unit; a wind condition data acquisition unit configured to acquire wind condition data; and a cooling control unit configured to control an operation of the first cooling unit in accordance with the wind condition data acquired by the wind condition data acquisition unit.

The present disclosure enables efficient power generation.

### BRIEF DESCRIPTION OF THE DRAWINGS

Fig. 1 is a diagram of an overall configuration of a wind turbine generator system according to an embodiment of the disclosure;
Fig. 2 is a block diagram of a functional configuration of the wind turbine generator system illustrated in Fig. 1;
Fig. 3A is a diagram of ON/OFF control on cooling fans in a power conversion assembly in accordance with temperature changes;
Fig. 3B is a diagram of ON/OFF control on a speed increaser assembly cooling fan and a power generator assembly cooling fan in accordance with temperature changes;
Fig. 4A is a diagram of command patterns of speed command values to control the cooling fans provided in the power conversion assembly;
Fig. 4B is a diagram of command patterns of speed command values to control the speed increaser assembly cooling fan and the power generator assembly cooling fan;
Fig. 5A is a diagram of a variation in rotation speed of a rotation shaft; and
Fig. 5B is a diagram of electric power consumed by the cooling fans.

### DETAILED DESCRIPTION

The embodiment will now be described with reference to the drawings. Like reference figures indicate like components in the drawings, and a duplicate description will be omitted.

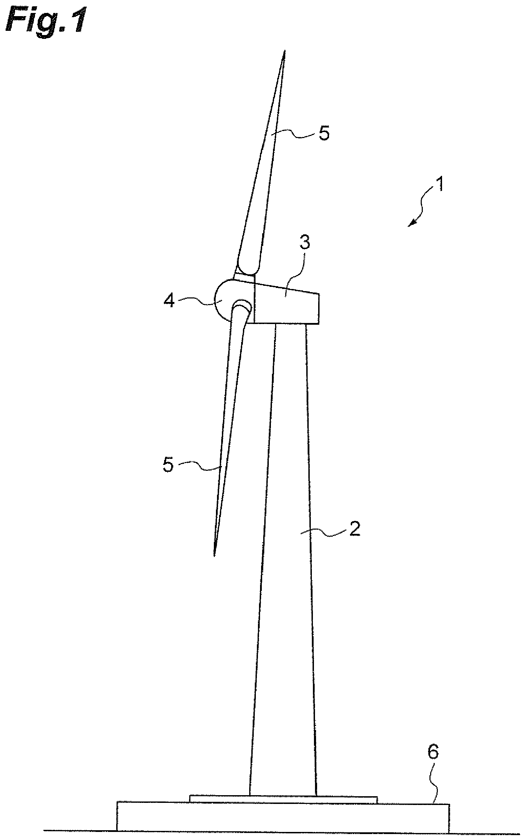

As illustrated in Fig. 1, a wind turbine generator system 1 includes a tower 2, a nacelle 3, a hub 4, and a plurality of blades 5. The tower 2 is installed on a foundation 6 and extends upward therefrom. The nacelle 3 is installed on the tower 2 at its upper end. The hub 4 is provided on the nacelle 3 and rotates about an axis line extending substantially in a horizontal direction. The plurality of blades 5 (for example, there are three of them) is attached on the hub 4 so as to radiate from the rotation axis of the hub 4.

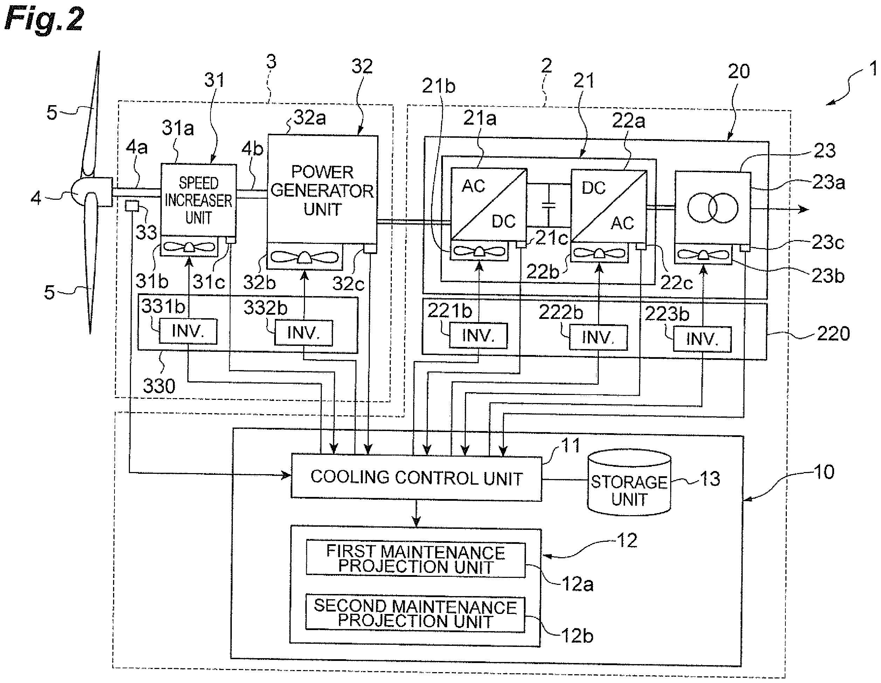

As illustrated in Fig. 2, the nacelle 3 includes therein a speed increaser assembly 31, a power generator assembly 32, a rotation speed detection sensor (a wind condition data acquisition unit) 33, and an inverter assembly 330. The speed increaser assembly 31 includes a speed increaser unit 31a, a speed increaser assembly cooling fan 31b, and a speed increaser assembly temperature sensor 31c. The speed increaser unit 31a, which is connected to a rotation shaft 4a extending from the hub 4 that is rotated by the blades 5 receiving wind, increases the number of revolutions of the rotation shaft 4a. The speed increaser assembly cooling fan 31b blows air to cool the speed increaser unit 31a. The number of revolutions of the speed increaser assembly cooling fan 31b is controlled by the inverter assembly 330. The speed increaser assembly temperature sensor 31c detects a temperature of the speed increaser unit 31a.

The power generator assembly 32 includes a power generator unit 32a, a power generator assembly cooling fan (a second cooling unit) 32b, and a power generator assembly temperature sensor (a second temperature detection unit) 32c. The power generator unit 32a receives the torque of a rotation shaft 4b having a rotation speed increased by the speed increaser assembly 31 to generate electric power with the input torque. The power generator assembly cooling fan 32b blows air to cool the power generator unit 32a. The number of revolutions of the power generator assembly cooling fan 32b is controlled by the inverter assembly 330. The power generator assembly temperature sensor 32c detects a temperature of the power generator unit 32a. As the power generator assembly 32, for example, a synchronous generator or an instruction generator, etc. may be employed.

The rotation speed detection sensor 33 detects the rotation speed of the rotation shaft 4a. With the rotation speed detection sensor 33 detecting the rotation speed of the rotation shaft 4a, a level of a wind speed and the like can be estimated as wind condition data.

The inverter assembly 330 includes a first inverter (INV.) 331b and a second inverter (INV.) 332b. The first inverter 331b controls the rotation of the speed increaser assembly cooling fan 31b in accordance with a speed command value from a cooling control unit 11 of a controller 10 to be described hereinafter. Similarly, the second inverter 332b controls the rotation of the power generator assembly cooling fan 32b in accordance with a speed command value from the cooling control unit 11.

The tower 2 includes therein the controller 10, a power conversion assembly 20, and an inverter assembly 220. The power conversion assembly 20 includes a converter 21 and a transformer 23. The converter 21 converts the frequency of the electric power generated by the power generator assembly 32. To provide an example, the converter 21 according to this embodiment includes an AC/DC conversion unit 21a, a converter cooling fan (a first cooling unit) 21b, and a converter temperature sensor (a first temperature detection unit) 21c, and a DC/AC conversion unit 22a, a converter cooling fan (the first cooling unit) 22b, and a converter temperature sensor (the first temperature detection unit) 22c. The frequency of the electric power generated by the power generator assembly 32 is converted to a predetermined frequency by the AC/DC conversion unit 21a and the DC/AC conversion unit 22a. Note that a matrix converter, which directly converts AC to AC at a predetermined frequency, may be used as the converter 21. In such a case, the matrix converter includes a conversion unit, which directly converts AC to AC at the predetermined frequency, a converter cooling fan (the first cooling unit), and a converter temperature sensor (the first temperature detection unit).

The converter cooling fan 21b blows air to cool the AC/DC conversion unit 21a. The number of revolutions of the converter cooling fan 21b is controlled by the inverter assembly 220. The converter temperature sensor 21c detects a temperature of the AC/DC conversion unit 21a. The converter cooling fan 22b blows air to cool the DC/AC conversion unit 22a. The number of revolutions of the converter cooling fan 22b is controlled by the inverter assembly 220. The converter temperature sensor 22c detects a temperature of the DC/AC conversion unit 22a.

The transformer 23 includes a voltage conversion unit 23a, a transformer cooling fan (the first cooling unit) 23b, and a transformer temperature sensor (the first temperature detection unit) 23c. The voltage conversion unit 23a performs voltage conversion on the electric power undergone the frequency conversion by the converter 21. The transformer cooling fan 23b blows air to cool the voltage conversion unit 23a. The number of revolutions of the transformer cooling fan 23b is controlled by the inverter assembly 220. The transformer temperature sensor 23 c detects a temperature of the voltage conversion unit 23 a.

The inverter assembly 220 includes a first inverter (INV.) 221b, a second inverter (INV.) 222b, and a third inverter (INV.) 223b. The first inverter 221b controls the rotation of the converter cooling fan 21b in accordance with a speed command value from the cooling control unit 11. Similarly, the second inverter 222b controls the rotation of the converter cooling fan 22b in accordance with a speed command value from the cooling control unit 11. The third inverter 223b controls the rotation of the transformer cooling fan 23b in accordance with a speed command value from the cooling control unit 11.

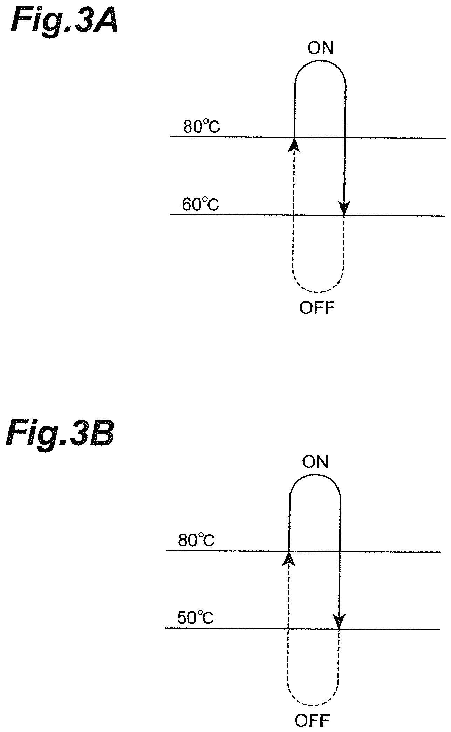

The controller 10 includes the cooling control unit 11, a maintenance projection unit 12, and a storage unit 13. The cooling control unit 11 outputs speed command values to the inverters, such as the first inverter 221b, for the numbers of revolutions of the cooling fans, such as the converter cooling fan 21b, for the operations thereof. As illustrated in Fig. 3A, the cooling control unit 11 allows the converter cooling fan 21b to operate (ON) when the converter temperature sensor 21c detects that the temperature of the AC/DC conversion unit 21a is equal to or more than 80°C. Note that the cooling control unit 11 may acquire a result of the detection by the rotation speed detection sensor 33 via another controller that controls entirely the wind turbine generator system 1. The cooling control unit 11 may also acquire a result of the detection by the converter temperature sensor 21c via the other controller that controls entirely the wind turbine generator system 1. The cooling control unit 11 may also acquire a result of detection by any of the other temperature sensors, such as the converter temperature sensor 22c, via the other controller that controls entirely the wind turbine generator system 1. The cooling control unit 11 also allows the converter cooling fan 21b to stop operating (OFF) when the converter temperature sensor 21c detects that the temperature of the AC/DC conversion unit 21a is less than 60°C with the converter cooling fan 21b operating.

As in the case of the converter cooling fan 21b, the cooling control unit 11 allows the converter cooling fan 22b to operate when the converter temperature sensor 22c detects that the temperature of the DC/AC conversion unit 22a is equal to or more than 80°C, and allows the converter cooling fan 22b to stop operating when the converter temperature sensor 22c detects that the temperature of the DC/AC conversion unit 22a is less than 60°C with the converter cooling fan 22b operating. As in the case of the converter cooling fan 21b, the cooling control unit 11 allows the transformer cooling fan 23b to operate when the transformer temperature sensor 23c detects that the temperature of the voltage conversion unit 23a is equal to or more than 80°C, and allows the transformer cooling fan 23b to stop operating when the transformer temperature sensor 23c detects that the temperature of the voltage conversion unit 23a is less than 60°C.

Furthermore, the cooling control unit 11 allows the speed increaser assembly cooling fan 31b to operate when the speed increaser assembly temperature sensor 31c detects that the temperature of the speed increaser unit 31a is equal to or more than 80°C as illustrated in Fig. 3B. The cooling control unit 11 also allows the speed increaser assembly cooling fan 31b to stop operating when the speed increaser assembly temperature sensor 31c detects that the temperature of the speed increaser unit 31a is less than 50°C with the speed increaser assembly cooling fan 31b operating.

As in the case of the speed increaser assembly cooling fan 31b, the cooling control unit 11 allows the power generator assembly cooling fan 32b to operate when the power generator assembly temperature sensor 32c detects that the temperature of the power generator unit 32a is equal to or more than 80°C. The cooling control unit 11 also allows the power generator assembly cooling fan 32b to stop operating when the power generator assembly temperature sensor 32c detects that the temperature of the power generator unit 32a is less than 50°C with the power generator assembly cooling fan 32b operating.

As described above, the cooling control unit 11 switches ON/OFF the cooling fans, such as the converter cooling fan 21b, in accordance with temperatures detected by the temperature sensors, such as the converter temperature sensor 21c. Note that temperature limits such as 50°C, 60°C, and 80°C described above for the switching ON/OFF are provided as examples and can be set otherwise according to various conditions.

Furthermore, the cooling control unit 11 determines speed command values in accordance with command patterns of speed command values stored in the storage unit 13 to control the operations of the cooling fans, such as the converter cooling fan 21b. A command pattern of speed command values stored in the storage unit 13 will now be described. The storage unit 13 stores a command pattern of speed command values for the number of revolutions of each cooling fan for the speed increaser unit 31a, the power generator unit 32a, the AC/DC conversion unit 21a, the DC/AC conversion unit 22a, and the voltage conversion unit 23a, which are to be cooled by the cooling fans. Each command pattern of speed command values includes speed command values for one of the cooling fans in association with temperatures of a relevant unit to be cooled. Note that a command pattern is not limited to that in the form of a graph and may be data in various forms that includes speed command values for a cooling fan in association with temperatures of a relevant unit to be cooled, such as a table that allows data processing.

Each command pattern of speed command values includes speed command values set in consideration of a thermal time constant of a relevant unit to be cooled. This allows cooling appropriate for each unit to be cooled in proportion to a thermal characteristic thereof, such as difficulty or ease with which each unit is cooled. Additionally, a speed command value is set for a rotation speed detected by the rotation speed detection sensor 33, in other words, a load to be applied to each unit to be cooled during the electric power generation. As the rotation speed detected by the rotation speed detection sensor 33 increases, the power output increases. This in turn increases the load and an upward variation in temperature of each unit to be cooled.

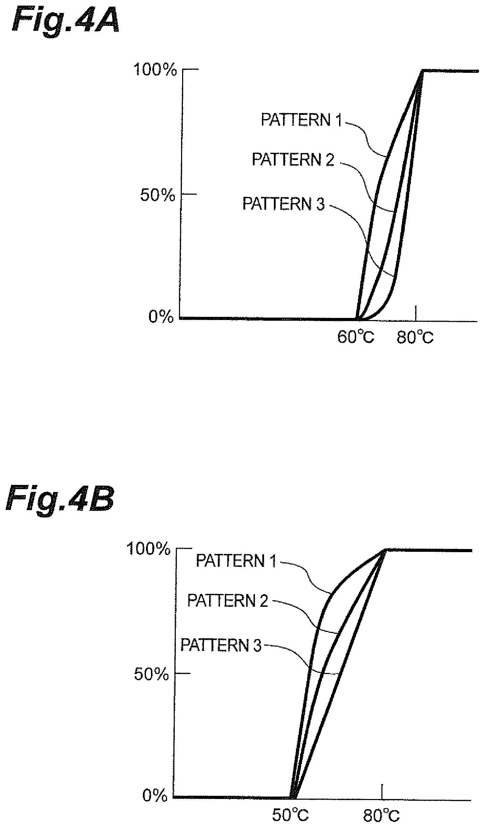

To provide a specific example, command patterns of speed command values to be used by the cooling control unit 11 to control the converter cooling fan 21b will now be described with reference to Fig. 4A. As illustrated in Fig. 4A, three command patterns of speed command values are set for different loads to be applied to the AC/DC conversion unit 21a during the electric power generation for inputting into the first inverter 221b to operate the converter cooling fan 21b. A pattern 1 includes speed command values for a full load, a pattern 2 includes speed command values for a 50%-load, and a pattern 3 includes speed command values for a 0%-load and for after-cooling.

In the example illustrated in Fig. 4A, all the command patterns of speed command values include speed command values set to allow the converter cooling fan 21b to achieve a 100% rotation speed of its maximum rotation speed when the converter temperature sensor 21c detects that the temperature is equal to or more than 80°C. Conversely, all the command patterns of speed command values include speed command values set to allow the converter cooling fan 21b to achieve a 0% rotation speed of its maximum rotation speed or to stop operating when the converter temperature sensor 21c detects that the temperature is less than 60°C.

In the example illustrated in Fig. 4A, when the converter temperature sensor 21c detects that the temperature is equal to or more than 60°C and less than 80°C, higher speed command values are set in the order of the pattern 1, the pattern 2, and the pattern 3. The speed command values are varied in such a manner with loads applied to the AC/DC conversion unit 21a. In this example, a higher speed command value is set for a higher load. This provides a higher speed command value for the converter cooling fan 21b for a higher load applied to the AC/DC conversion unit 21a, resulting in a higher rotation speed and thereby an increased cooling capacity of the converter cooling fan 21b.

To provide another specific example, command patterns of speed command values to be used by the cooling control unit 11 to control the power generator assembly cooling fan 32b will now be described with reference to Fig. 4B. As illustrated Fig. 4B, three command patterns of speed command values are set for different loads to be applied to the power generator unit 32a during the electric power generation for inputting into the second inverter 332b to operate the power generator assembly cooling fan 32b, as in the case of the speed command values illustrated in Fig. 4A. A pattern 1 includes speed command values for the full load, a pattern 2 includes speed command values for the 50%-load, and a pattern 3 includes speed command values for the 0%-load and for the after-cooling.

In the example illustrated in Fig. 4B, when the power generator assembly temperature sensor 32c detects that the temperature is equal to or more than 50°C and less than 80°C, higher speed command values are set in the order of the pattern 1, the pattern 2, and the pattern 3. The speed command values are varied in such a manner with loads applied to the power generator unit 32a. In this example, a higher speed command value is set for a higher load.

Although three command patterns of speed command values are set for different loads to be applied to each unit to be cooled in the examples illustrated in Figs. 4A and 4B, the number of command patterns is not limited to three. The form of a curve of speed command values (the manner in which the values are varied) for a command pattern of speed command values is also not limited to those illustrated in Figs. 4A and 4B.

The storage unit 13 stores command patterns of speed command values to be used to control the converter cooling fan 22b and the transformer cooling fan 23b, as in the case of the command patterns of speed command values for the control of the converter cooling fan 21b (see Fig. 4A). The storage unit 13 also stores command patterns of speed command values to be used to control the speed increaser assembly cooling fan 31b, as in the case of the command patterns of speed command values for the control of the power generator assembly cooling fan 32b (see Fig. 4B).

To control the rotation of the converter cooling fan 21b, the cooling control unit 11 references the command patterns of speed command values (see Fig. 4A) stored in the storage unit 13 and selects an optimum pattern from among the three command patterns of speed command values in accordance with a rotation speed (which is a load) detected by the rotation speed detection sensor 33. The cooling control unit 11 then determines a speed command value in accordance with the selected command pattern of speed command values and a temperature detected by the converter temperature sensor 21c. Here, the cooling control unit 11 determines the speed command value in consideration also of the ON/OFF control performed on the converter cooling fan 21b in accordance with a temperature change, as described with reference to Fig. 3A. The cooling control unit 11 outputs the determined speed command value to the first inverter 221b.

To control one of the cooling fans (the converter cooling fan 22b, the power generator assembly cooling fan 32b, or the like) other than the converter cooling fan 21b, the cooling control unit 11 also references command patterns of speed command values stored in the storage unit 13, as in the case of the control of the converter cooling fan 21b, and selects an optimum command pattern from among a plurality of command patterns of speed command values in accordance with a rotation speed detected by the rotation speed detection sensor 33. The cooling control unit 11 then determines a speed command value in accordance with the command pattern of speed command values stored in the storage unit 13 and a temperature detected by a relevant temperature sensor (the converter temperature sensor 22c, the power generator assembly temperature sensor 32c, or the like) that detects the temperature of a relevant unit to be cooled. Here, the cooling control unit 11 determines the speed command value in consideration also of the ON/OFF control performed on the cooling fan in accordance with a temperature change, as described with reference to Figs. 3A and 3B. The cooling control unit 11 outputs the determined speed command value to a relevant inverter (the second inverter 222b, second inverter 332b, or the like) that controls the cooling fan.

To perform the after-cooling after the electric power generation is stopped, the cooling control unit 11 selects a command pattern of speed command values for the after cooling from among command patterns of speed command values stored in the storage unit 13, determines a speed command value in accordance with the selected command pattern of speed command values and a temperature detected by a relevant temperature sensor, and outputs the determined speed command value to a relevant inverter.

As described above, the cooling control unit 11 increases the cooling capacities of the cooling fans, such as the power generator assembly cooling fan 32b, when the rotation speed (a wind condition) detected by the rotation speed detection sensor 33 is high, in other words, when the wind is high, because loads applied to the units to be cooled, such as the power generator assembly 32, are increased. Conversely, the cooling control unit 11 reduces the cooling capacities of the cooling fans, such as the power generator assembly cooling fan 32b, when the rotation speed detected by the rotation speed detection sensor 33 is low, in other words, when the wind is low, because loads applied to the units to be cooled, such as the power generator assembly 32, are reduced. This allows each cooling fan, such as the power generator assembly cooling fan 32b, to be controlled appropriately to a rotation speed detected by the rotation speed detection sensor 33, in other words, a load applied to each unit to be cooled, such as the power generator assembly 32.

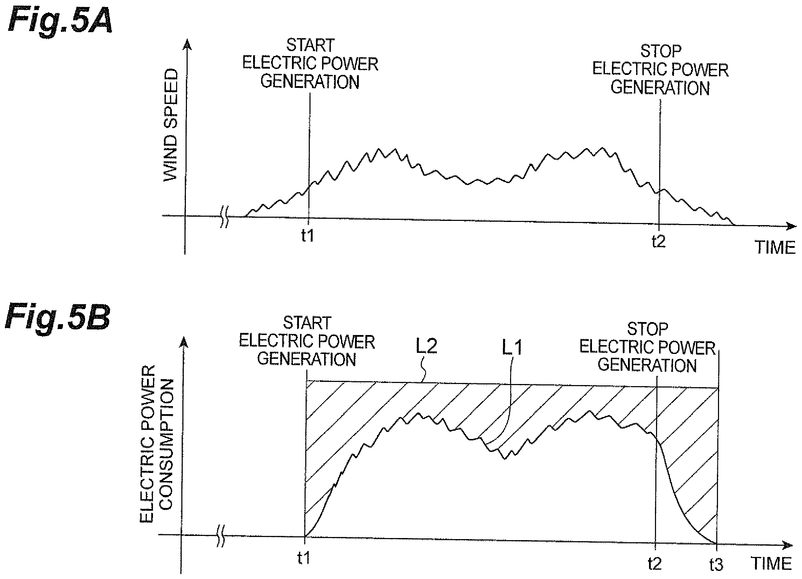

A change in electric power consumed by the cooling fans in the wind turbine generator system 1 with the cooling fans, such as the power generator assembly cooling fan 32b, controlled in accordance with the result of the detection by the rotation speed detection sensor 33 will now be described. In an example as illustrated in Fig. 5A, the wind speed varies with time, also varying the rotation speed detected by the rotation speed detection sensor 33. In this case, the electric power generation is started at a time t1 when the wind speed has increased. The electric power generation is then stopped at a time t2 when the wind speed has decreased.

The cooling control unit 11 varies the cooling capacities of all the cooling fans, including the converter cooling fan 21b, in the wind turbine generator system 1 with the rotation speed detected by the rotation speed detection sensor 33. Thus, a total value of electric power consumed by all the cooling fans (the speed increaser assembly cooling fan 31b, the power generator assembly cooling fan 32b, the converter cooling fan 21b, the converter cooling fan 22b, and the transformer cooling fan 23b) also varies from the time t1 to the time t2 with the rotation speed detected by the rotation speed detection sensor 33 as marked with a line L1 in Fig. 5B. The cooling control unit 11 also controls each cooling fan in such a manner that the after-cooling is performed from the time t2 to a time t3. During the after-cooling, the cooling control unit 11 reduces gradually speed command values as the temperatures of the units to be cooled, such as the power generator unit 32a, decrease (see speed command values of the patterns 3 illustrated in Figs. 4A and 4B). Thus, during the after-cooling, the total value of electric power consumed by all the cooling fans also decreases gradually.

For comparison, if the cooling control unit 11 performs, for example, constant control on each cooling fan to achieve a maximum cooling capacity thereof from the time t1 when the electric power generation is started to the time t3 when the after-cooling is finished, the total value of electric power consumed by all the cooling fans is also constant from the time t1 to the time t3 as marked with a line L2 in Fig. 5B. Hence, by varying the rotation speed of each cooling fan with the result of the detection by the rotation speed detection sensor 33, the electric power consumption can be reduced by the consumed electric power between the line L2 and the line L1.

With reference to Fig. 2, the maintenance projection unit 12 includes a first maintenance projection unit 12a and a second maintenance projection unit 12b. The first maintenance projection unit 12a projects maintenance timings for the converter cooling fan 21b, the converter cooling fan 22b, and the transformer cooling fan 23b with, for example, the lives of their components considered in accordance with a past condition of the control by the cooling control unit 11 on these cooling fans. In addition to the maintenance timing, other information, such as operation hours up to present, may also be output.

To project a maintenance timing for, for example, the converter cooling fan 21b, the first maintenance projection unit 12a acquires from the cooling control unit 11a speed command value output to the first inverter 221b for the control of the converter cooling fan 21b. The first maintenance projection unit 12a calculates the total number of revolutions, total operation hours, or the like of the converter cooling fan 21b from the acquired speed command value and projects a maintenance timing based on, for example, a preset service life of the converter cooling fan 21b. Similarly, the first maintenance projection unit 12a acquires speed command values output to the second inverter 222b and the third inverter 223b to project maintenance timings for the converter cooling fan 22b and the transformer cooling fan 23b.

The second maintenance projection unit 12b projects maintenance timings for the speed increaser assembly cooling fan 31b and the power generator assembly cooling fan 32b with, for example, the lives of their components considered in accordance with a past condition of the control by the cooling control unit 11 on these cooling fans. Specifically, the second maintenance projection unit 12b acquires from the cooling control unit 11 speed command values output to the first inverter 331b and the second inverter 332b, as in the case of the first maintenance projection unit 12a, to project maintenance timings for the speed increaser assembly cooling fan 31b and the power generator assembly cooling fan 32b.

In the embodiment configured as described above, the wind turbine generator system 1 allows the converter cooling fan 21b, the converter cooling fan 22b, and the transformer cooling fan 23b, which are provided in the power conversion assembly 20, to be controlled in accordance with the rotation speed of the rotation shaft 4a detected by the rotation speed detection sensor 33, which is, in other words, the wind condition data. This enables control, for example, to reduce the cooling capacities of the cooling fans (i.e., to reduce the numbers of revolutions thereof) when the wind speed is low and thus the rotation speed of the rotation shaft 4a is low. Hence, the electric power consumed by the cooling fans provided in the power conversion assembly 20 can be restricted. Consequently, the wind turbine generator system 1 capable of generating electric power efficiently with the amount of the electric power consumed by the cooling fans restricted can be provided. Additionally, when the wind speed is low, the cooling capacities of the converter cooling fan 21b, the converter cooling fan 22b, and the transformer cooling fan 23b are reduced, in other words, the numbers of revolutions of the cooling fans are reduced, achieving prolonged lives of the cooling fans (for example, a bearing included in one of the cooling fans). Thanks to this, maintenance frequency can be reduced, and thus running costs of the wind turbine generator system 1 can be restricted.

The cooling control unit 11 controls the converter cooling fan 21b, the converter cooling fan 22b, and the transformer cooling fan 23b in consideration also of the temperatures detected by the converter temperature sensor 21c, the converter temperature sensor 22c, and the transformer temperature sensor 23 c, respectively. This enables feedback control of the converter cooling fan 21b, the converter cooling fan 22b, and the transformer cooling fan 23b in accordance with the present temperatures of the AC/DC conversion unit 21a, the DC/AC conversion unit 22a, and the voltage conversion unit 23 a, respectively.

The storage unit 13 stores command patterns of speed command values with a thermal time constant considered. The cooling control unit 11 determines speed command values for the control of the converter cooling fan 21b, the converter cooling fan 22b, and the transformer cooling fan 23b in accordance with command patterns of speed command values with thermal time constants considered. This enables cooling appropriate for each of the AC/DC conversion unit 21a, the DC/AC conversion unit 22a, and the voltage conversion unit 23 a to be cooled in proportion to a thermal characteristic of each of these units to be cooled. Additionally, since speed command values are set in consideration of a thermal time constant of each unit to be cooled, the effect of restricting the consumption of electric power varies with the cooling fans. Generally, a thermal time constant of the converter 21 (the AC/DC conversion unit 21a and the DC/AC conversion unit 22a) is (significantly) smaller than thermal time constants of the speed increaser unit 31a and the power generator unit 32a, and thus variations in the numbers of revolutions of the cooling fans for the converter 21 are larger than those for the speed increaser unit 31a and the power generator unit 32a in accordance with a variation in the wind speed. Thus, it can be expected that the effect of restricting the electric power consumed by the cooling fans provided in the converter 21 is especially large.

The first maintenance projection unit 12a acquires from the cooling control unit 11 speed command values for the control of the converter cooling fan 21b, the converter cooling fan 22b, and the transformer cooling fan 23b to project maintenance timings for the converter cooling fan 21b, the converter cooling fan 22b, and the transformer cooling fan 23b in accordance with the acquired speed command values. By using speed command values for the control of the cooling fans provided in the power conversion assembly 20 in this manner, their maintenance timings can be projected with ease.

Additionally, the cooling control unit 11 controls the speed increaser assembly cooling fan 31b in the speed increaser assembly 31 and the power generator assembly cooling fan 32b in the power generator assembly 32 in accordance with the rotation speed of the rotation shaft 4a detected by the rotation speed detection sensor 33. This enables control, for example, to reduce the cooling capacities of the cooling fans (i.e., to reduce the numbers of revolutions thereof) when the wind speed is low and thus the rotation speed of the rotation shaft 4a is low. Hence, the electric power consumed by the cooling fans provided in the speed increaser assembly 31 and the power generator assembly 32 can be restricted. Consequently, the wind turbine generator system 1 capable of generating electric power further efficiently can be provided. Additionally, when the wind speed is low, the cooling capacities of the speed increaser assembly cooling fan 31b and the power generator assembly cooling fan 32b are reduced, in other words, the numbers of revolutions of the cooling fans are reduced, achieving prolonged lives of the cooling fans (for example, a bearing included in one of the cooling fans). Thanks to this, maintenance frequency can be reduced, and thus the running costs of the wind turbine generator system 1 can be restricted.

The cooling control unit 11 controls the speed increaser assembly cooling fan 31b and the power generator assembly cooling fan 32b in consideration also of the temperatures detected by the speed increaser assembly temperature sensor 31c and the power generator assembly temperature sensor 32c, respectively. This enables feedback control of the speed increaser assembly cooling fan 31b and the power generator assembly cooling fan 32b in accordance with the present temperatures of the speed increaser unit 31a and the power generator unit 32a, respectively.

The storage unit 13 stores command patterns of speed command values with a thermal time constant considered. The cooling control unit 11 determines speed command values for the control of the speed increaser assembly cooling fan 31b and the power generator assembly cooling fan 32b in accordance with command patterns of speed command values with thermal time constants considered. This enables cooling appropriate for each of the speed increaser unit 31a and the power generator unit 32a to be cooled in proportion to a thermal characteristic of each of these units to be cooled.

The second maintenance projection unit 12b acquires from the cooling control unit 11 speed command values for the control of the speed increaser assembly cooling fan 31b and the power generator assembly cooling fan 32b to project maintenance timings for the speed increaser assembly cooling fan 31b and the power generator assembly cooling fan 32b in accordance with the acquired speed command values. By using speed command values for the control of the cooling fans in this manner, their maintenance timings can be projected with ease.

Although an embodiment of the disclosure has been described, the present invention is not limited thereto. For example, the rotation speed of the rotation shaft 4a detected by the rotation speed detection sensor 33 is used as the wind condition data indicative of a condition of wind received by the blades 5 in the embodiment described above, but other data indicative of a wind condition, for example, a result of detection by a measuring instrument that measures a wind speed, may be used.

Although the cooling fans, such as the converter cooling fan 21b, are used in the embodiment described above to cool the units to be cooled, such as the AC/DC conversion unit 21a, the cooling is not limited to that by a device that blows air. For example, a cooling device of a water-cooling type that supplies water to cool a unit to be cooled may be used, in which case, the cooling control unit 11 may control a water-cooling pump and the like. Alternatively, a unit to be cooled (such as the AC/DC conversion unit 21a) and a cooling fan (such as the converter cooling fan 21b) may be integrated. For example, a chiller or the like may be used to cool a unit to be cooled, in which case, the unit to be cooled and the chiller may be disposed at separate locations.

Although the power conversion assembly 20 is provided in the tower 2 in the embodiment described above, it is not limited to the tower 2. The power conversion assembly 20 may be provided in the nacelle 3 or any other place in lieu of the tower 2 and the nacelle 3. Additionally, the controller 10 may be provided in the nacelle 3 or any other place in lieu of the tower 2 and the nacelle 3.

A device provided in the wind turbine generator system 1, such as the controller 10 and the power conversion assembly 20, may be turned OFF in a case where the electric power generation is not performed due to a low wind. In this manner, a consumption of standby power by a device provided in the wind turbine generator system 1 can be restricted.

## Claims

1. A wind turbine generator system (1) for generating electric power from wind power, the system comprising:
a conversion unit (21a, 22a, 23a) configured to convert the electric power generated;
a first cooling unit (21b, 22b, 23b) configured to cool the conversion unit (21a, 22a, 23a);
a wind condition data acquisition unit (33) configured to acquire wind condition data; and
a cooling control unit (11) configured to control an operation of the first cooling unit (21b, 22b, 23b);
a first temperature detection unit (21c, 22c, 23c) configured to detect a temperature of the conversion unit (21a, 22a, 23a), and
wherein the cooling control unit (11) switches ON/OFF the first cooling unit (21b, 22b, 23b) in accordance further with the temperature of the conversion unit (21a, 22a, 23a) detected by the first temperature detection unit (21c, 22c, 23c), **characterised in that** the wind turbine generator system further comprises a storage unit (13) configured to store a plurality of command patterns of the speed command values used by the cooling control unit (11) to control the rotation speed of the cooling fan of the first cooling unit (21b, 22b, 23b) and **in that** to allow the first cooling unit (21b, 22b, 23b) to operate, the cooling control unit (11) selects an optimum command pattern in accordance with the wind condition data from among a plurality of the command patterns stored in the storage unit (13), and controls the rotation speed of the cooling fan in accordance with the selected command pattern.

2. The wind turbine generator system (1) according to claim 1, wherein the conversion unit (21a, 22a, 23a) and the first cooling unit (21b, 22b, 23b) make up a power conversion assembly (20).

3. The wind turbine generator system (1) according to any one of claims 1 to 2, wherein the cooling control unit (11) controls the operation of the first cooling unit (21b, 22b, 23b) in accordance further with a thermal time constant of the conversion unit (21a, 22a, 23a).

4. The wind turbine generator system (1) according to any one of claims 1 to 3, further comprising a first maintenance projection unit (12a) configured to project a maintenance timing for the first cooling unit (21b, 22b, 23b) in accordance with a past condition of the control by the cooling control unit (11) on the first cooling unit (21b, 22b, 23b).

5. The wind turbine generator system (1) according to any one of claims 1 to 3, further comprising:
a power generator unit (32a) configured to generate the electric power from wind power; and
a second cooling unit (32b) configured to cool the power generator unit (32a),
wherein the cooling control unit (11) further controls an operation of the second cooling unit (32b) in accordance with the wind condition data acquired by the wind condition data acquisition unit (33).

6. The wind turbine generator system (1) according to claim 5, wherein the power generator unit (32a) and the second cooling unit (32b) make up a power generator assembly (32).

7. The wind turbine generator system (1) according to claim 5 or 6, further comprising
a second temperature detection unit (32c) configured to detect a temperature of the power generator unit (32a),
wherein the cooling control unit (11) controls the operation of the second cooling unit (32b) in accordance further with the temperature of the power generator unit (32a) detected by the second temperature detection unit (32c).

8. The wind turbine generator system (1) according to any one of claims 5 to 7, wherein the cooling control unit (11) controls the operation of the second cooling unit (32b) in accordance further with a thermal time constant of the power generator unit (32a).

9. The wind turbine generator system (1) according to any one of claims 5 to 8, further comprising a second maintenance projection unit (12b) configured to project a maintenance timing for the second cooling unit (32b) in accordance with a past condition of the control by the cooling control unit (11) on the second cooling unit (32b).

## Patentansprüche

1. Ein Windturbine-Generatorsystem (1) zum Erzeugen von elektrischem Strom aus Windkraft, wobei das System aufweist:
eine Umwandlungseinheit (21a, 22a, 23a), die gestaltet ist, um den erzeugten elektrischen Strom umzuwandeln,
eine erste Kühleinheit (21b, 22b, 23b), die gestaltet ist, um die Umwandlungseinheit (21a, 22a, 23a) zu kühlen,
eine Windbedingungsdaten-Erfassungseinheit (33), die gestaltet ist, um Windbedingungsdaten zu erfassen, und
eine Kühlung-Steuerungseinheit (11), die gestaltet ist, um einen Betrieb der ersten Kühleinheit (21b, 22b, 23b) zu steuern,
eine erste Temperatur-Detektiereinheit (21c, 22c, 23c), die gestaltet ist, um eine Temperatur der Umwandlungseinheit (21a, 22a, 23a) zu detektieren, und
wobei die Kühlung-Steuerungseinheit (11) die erste Kühleinheit (21b, 22b, 23b) EIN/AUS schaltet gemäß ferner der Temperatur der Umwandlungseinheit (21a, 22a, 23a), die von der ersten Temperatur-Detektiereinheit (21c, 22c, 23c) detektiert wird,
**dadurch gekennzeichnet, dass** das Windturbine-Generatorsystem ferner eine Speichereinheit (13) aufweist, die gestaltet ist, um eine Mehrzahl von Befehlsmustern der Geschwindigkeit-Befehlswerte zu speichern, die von der Kühlung-Steuerungseinheit (11) verwendet werden, um die Rotationsgeschwindigkeit des Kühlventilators der ersten Kühleinheit (21b, 22b, 23b) zu steuern, und dadurch, dass, um der ersten Kühleinheit (21b, 22b, 23b) einen Betrieb zu erlauben, die Kühlung-Steuereinheit (11) gemäß der Windbedingungsdaten ein optimales Befehlsmuster aus einer Mehrzahl der in der Speichereinheit (13) gespeicherten Befehlsmuster auswählt und die Rotationsgeschwindigkeit des Kühlventilators gemäß dem ausgewählten Befehlsmuster steuert.

2. Das Windturbine-Generatorsystem (1) gemäß Anspruch 1 wobei die Umwandlungseinheit (21a, 22a, 23a) und die erste Kühleinheit (21b, 22b, 23b) eine Strom-Umwandlungseinrichtung (20) bilden.

3. Das Windturbine-Generatorsystem (1) gemäß irgendeinem der Ansprüche 1 bis 2, wobei die Kühlung-Steuerungseinheit (11) den Betrieb der ersten Kühleinheit (21b, 22b, 23b) ferner gemäß einer thermischen Zeitkonstanten der Umwandlungseinheit (21a, 22a, 23a) steuert.

4. Das Windturbine-Generatorsystem (1) gemäß irgendeinem der Ansprüche 1 bis 3, ferner aufweisend eine erste Wartung-Vorhersageeinheit (12a), die gestaltet ist, um ein Wartungs-Timing für die erste Kühleinheit (21b, 22b, 23b) vorherzusagen gemäß einem vergangenen Zustand der Steuerung durch die Kühlung-Steuerungseinheit (11) auf der ersten Kühleinheit (21b, 22b, 23b).

5. Das Windturbine-Generatorsystem (1) gemäß irgendeinem der Ansprüche 1 bis 3, ferner aufweisend:
eine Strom-Generatoreinheit (32a), die gestaltet ist, um den elektrischen Strom aus Windkraft zu erzeugen, und
eine zweite Kühleinheit (32b), die gestaltet ist, um die Strom-Generatoreinheit (32a) zu kühlen,
wobei die Kühlung-Steuerungseinheit (11) ferner einen Betrieb der zweiten Kühleinheit (32b) steuert gemäß der Windbedingungsdaten, die von der Windbedingungsdaten-Erfassungseinheit (33) erfasst werden.

6. Das Windturbine-Generatorsystem (1) gemäß Anspruch 5, wobei die Strom-Generatoreinheit (32a) und die zweite Kühleinheit (32b) eine Strom-Generatoreinrichtung (32) bilden.

7. Das Windturbine-Generatorsystem (1) gemäß Anspruch 5 oder 6, ferner aufweisend:
eine zweite Temperatur-Detektiereinheit (32c), die gestaltet ist, um eine Temperatur der Strom-Generatoreinheit (32a) zu detektieren,
wobei die Kühlung-Steuerungseinheit (11) den Betrieb der zweiten Kühleinheit (32b) ferner gemäß der Temperatur der Strom-Generatoreinheit (32a) steuert, die von der zweiten Temperatur-Detektiereinheit (32c) detektiert wird.

8. Das Windturbine-Generatorsystem (1) gemäß irgendeinem der Ansprüche 5 bis 7, wobei die Kühlung-Steuerungseinheit (11) den Betrieb der zweiten Kühleinheit (32b) ferner gemäß einer thermischen Zeitkonstante der Strom-Generatoreinheit (32a) steuert.

9. Das Windturbine-Generatorsystem (1) gemäß irgendeinem der Ansprüche 5 bis 8, ferner aufweisend eine zweite Wartung-Vorhersageeinheit (12b), die gestaltet ist, um ein Wartungs-Timing für die zweite Kühleinheit (32b) vorherzusagen gemäß einem vergangenen Zustand der Steuerung durch die Kühlung-Steuerungseinheit (11) auf der zweiten Kühleinheit (32b).

## Revendications

1. Système de générateur à turbine éolienne (1) destiné à générer une énergie électrique à partir de l'énergie éolienne, le système comprenant :
une unité de conversion (21a, 22a, 23a) configurée pour convertir l'énergie électrique générée ;
une première unité de refroidissement (21b, 22b, 23b) configurée pour refroidir l'unité de conversion (21a, 22a, 23a) ;
une unité d'acquisition de données de l'état des vents (33) configurée pour acquérir des données sur l'état des vents ; et
une unité de commande de refroidissement (11) configurée pour contrôler le fonctionnement de la première unité de refroidissement (21b, 22b, 23b) ;
une première unité de détection de température (21, 22c, 23c) configurée pour détecter une température de l'unité de conversion (21a, 22a, 23a), et
dans lequel l'unité de commande de refroidissement (11) active/désactive la première unité de refroidissement (21b, 22b, 23b) selon la température de l'unité de conversion (21a, 22a, 23a) détectée par la première unité de détection de température (21c, 22c, 23c), **caractérisé en ce que** le système de générateur à turbine éolienne comprend en outre une unité de stockage (13) configurée pour stocker une pluralité de modèles de commande des valeurs de commande de vitesse utilisées par l'unité de commande de refroidissement (11) afin de contrôler la vitesse de rotation du ventilateur de refroidissement de la première unité de refroidissement (21b, 22b, 23b), et **en ce que**
pour permettre à la première unité de refroidissement (21b, 22b, 23b) de fonctionner, l'unité de commande de refroidissement (11) sélectionne un modèle de commande optimal selon les données d'état des vents parmi une pluralité de modèles de commande stockés dans l'unité de stockage (13), et contrôle la vitesse de rotation du ventilateur de refroidissement selon le modèle de commande sélectionné.

2. Système de générateur à turbine éolienne (1) selon la revendication 1, dans lequel l'unité de conversion (21a, 22a, 23a) et la première unité de refroidissement (21b, 22b, 23b) constituent un ensemble de conversion d'énergie (20).

3. Système de générateur à turbine éolienne (1) selon l'une quelconque des revendications 1 à 2, dans lequel l'unité de commande de refroidissement (11) contrôle le fonctionnement de la première unité de refroidissement (21b, 22b, 23b) selon une constante de durée thermique de l'unité de conversion (21a, 22a, 23a).

4. Système de générateur à turbine éolienne (1) selon l'une quelconque des revendications 1 à 3, comprenant en outre une première unité de projection de maintenance (12a) configurée pour projeter un moment de maintenance pour la première unité de refroidissement (21b, 22b, 23b) selon une condition passée de la commande par l'unité de commande de refroidissement (11) sur la première unité de refroidissement (21b, 22b, 23b).

5. Système de générateur à turbine éolienne (1) selon l'une quelconque des revendications 1 à 3, comprenant en outre :
une unité de générateur d'énergie (32a) configurée pour générer l'énergie électrique à partir de l'énergie éolienne ; et
une seconde unité de refroidissement (32b) configurée pour refroidir l'unité de générateur d'énergie (32a),
dans lequel l'unité de commande de refroidissement (11) contrôle en outre le fonctionnement de la seconde unité de refroidissement (32b) selon les données d'état des vents acquises par l'unité d'acquisition de données d'état des vents (33).

6. Système de générateur à turbine éolienne (1) selon la revendication 5, dans lequel l'unité de générateur d'énergie (32a) et la seconde unité de refroidissement (32b) constituent un ensemble de générateur d'énergie (32).

7. Système de générateur à turbine éolienne (1) selon la revendication 5 ou 6, comprenant en outre
une seconde unité de détection de température (32c) configurée pour détecter une température de l'unité de générateur d'énergie (32a),
dans lequel l'unité de commande de refroidissement (11) contrôle le fonctionnement de la seconde unité de refroidissement (32b) selon la température de l'unité de générateur d'énergie (32a) détectée par la seconde unité de détection de température (32c).

8. Système de générateur à turbine éolienne (1) selon l'une quelconque des revendications 5 à 7, dans lequel l'unité de commande de refroidissement (11) contrôle le fonctionnement de la seconde unité de refroidissement (32b) selon une constante de durée thermique de l'unité de générateur d'énergie (32a).

9. Système de générateur à turbine éolienne (1) selon l'une quelconque des revendications 5 à 8, comprenant en outre une seconde unité de projection de maintenance (12b) configurée pour projeter un moment de maintenance pour la seconde unité de refroidissement (32b) selon une condition passée de la commande par l'unité de commande de refroidissement (11) sur la seconde unité de refroidissement (32b).
